# FASCICULE DE BREVET EUROPEEN

(11) **EP 0 531 197 B1**
(45) Date de publication et mention de la délivrance du brevet: **12.03.1997**
(21) Numéro de dépôt: 92402374.0
(22) Date de dépôt: 01.09.1992
(51) Int. Cl.: H01L 21/50, B23K 26/00

(54) **Procédé de fermeture par laser de boîtiers de circuits électroniques notamment hybrides minimisant les contraintes mécaniques**
Verfahren zur Laserverpackung von elektronischen Schaltungen, insbesondere für Hybrid-Schaltungen zur Minimisierung von Spannungen
Method of laser sealing electronic packages, in particular for hybrid packages with stress minimising

(30) Priorité: 03.09.1991 FR 9110863
(43) Date de publication de la demande: 10.03.1993
(73) Titulaire: THOMSON-CSF, 75008 Paris (FR)
(72) Inventeur: Cordelle, Christian, F-92045 Paris la Défense (FR); de Reynal, Florence, F-92045 Paris la Défense (FR); Goujard, Dominique, F-92045 Paris la Défense (FR); Sergent, Michel, F-92045 Paris la Défense (FR)
(74) Mandataire: Benoit, Monique

(56) Documents cités:
- EP-A- 0 362 045
- US-A- 4 521 668
- MICROWAVE JOURNAL, vol. 27, no. 11, novembre 1984, Dedham US, pages 169-179; G. SIMPSON : 'Laser-Welding The Large MIC - A new approach to Hermetic Sealing'
- IEEE TRANSACTIONS ON COMPONENTS, HYBRIDS, AND MANUFACTURING TECHNOLOGY, vol. CHMT-10, no. 3, septembre 1987, New York US, pages 433-436; T. SAKAI et al.: "A New Laser Hermetic Sealing Technique for Aluminum Package'

## Description

La présente invention concerne un procédé de fermeture par laser de boîtiers de circuits électroniques notamment hybrides minimisant les contraintes mécaniques. Elle s'applique plus particulièrement à la fermeture par laser d'hybrides de grande dimension appelés macro-hybrides, où un couvercle métallique est fermé sur un cadre lui-même brasé sur un fond en céramique portant des pistes sérigraphiées et des composants électroniques.

Plus généralement, l'invention s'applique à tous boîtiers d'hybrides dont il est nécessaire de minimiser les contraintes mécaniques liées à la fermeture par laser, tels que les boîtiers massifs tout en métal et de grande dimension par exemple.

Le procédé de fermeture par laser d'un boîtier métallique est connu de l'homme de l'art, il assure une soudure étanche par fusion du métal constituant le couvercle du boîtier. Un tel procédé de fermeture est par exemple décrit dans US-A-4 521 668. Les paramètres du laser sont déterminés en fonction de la nature des métaux et de l'épaisseur du couvercle. Dans le cas des macro-hybrides par exemple dont le fond est constitué d'un plateau en céramique supportant les circuits électroniques hybridés, le cadre est brasé sur ce fond en céramique et non sur un fond métallique. L'expérience a montré que toute contrainte apportée par une soudure au moyen d'un laser peut provoquer une défaillance au niveau du joint de brasure entre le cadre et la céramique. Ces contraintes sont en fait liées à l'échauffement des métaux qui se soudent. La déformation de l'ensemble ainsi créée empêche d'obtenir une étanchéité conforme aux normes en vigueur. Des solutions connues consistent par exemple à souder par transparence un couvercle en alliage fer-nickel sur un cadre en alliage fer-nickel ou en alliage fer-nickel-cobalt par exemple de telle façon que le faisceau du laser, partant d'un point du périmètre du macro-hybride, parcourt ce périmètre et revienne au point de départ. Cependant, ce type de solutions conduit aux déformations précitées et provoquées par les contraintes mécaniques exercées par la soudure par laser. En effet, avant fermeture, le fond en céramique d'un macro-hybride supportant le cadre brasé présente généralement une convexité de l'ordre de 100 à 200 µm due à la brasure avec le cadre, alors que le macro-hybride ayant une surface de l'ordre du dm², une fois fermé, présente une concavité de l'ordre de 100 à 200 µm correspondant aux contraintes appliquées sur le cadre par la soudure par laser. Il en résulte en conséquence des défauts d'étanchéité entre le cadre et le fond en céramique, empêchant toute encapsulation conforme à certaines normes imposées. De plus, lorsque la soudure par laser est réalisée continûment comme décrite ci-dessus, l'étanchéité entre le couvercle et le cadre n'est pas acquise en un seul passage, il est nécessaire alors de doubler, voire tripler le cordon de soudure dans les zones non étanches, cela contribue grandement à augmenter les contraintes exercées par la soudure et augmente les coûts de fabrication.

Le but de l'invention est de pallier les inconvénients précités.

A cet effet, l'invention a pour un objet un procédé de fermeture par laser de boîtiers de circuits électroniques notamment hybrides minimisant les contraintes mécaniques, le boîtier étant constitué d'un fond, d'un cadre et d'un couvercle métallique, la soudure du couvercle sur le cadre étant réalisée par déplacement du faisceau laser suivant un trajet donné sur le couvercle du boîtier,le trajet étant fermé, caractérisé en ce que le trajet de soudure est découpé en segments, deux segments consécutifs n'étant jamais soudés l'un à la suite de l'autre.

L'invention a pour principaux avantages qu'elle permet la réduction des contraintes exercées par la soudure par laser, qu'elle permet l'obtention de boîtiers étanches sans nécessité de reprise de soudure, qu'elle apporte une meilleure fiabilité et un meilleur rendement de production.

D'autres caractéristiques et avantages de l'invention apparaîtront à l'aide de la description qui suit faite en regard des dessins annexés qui représentent :

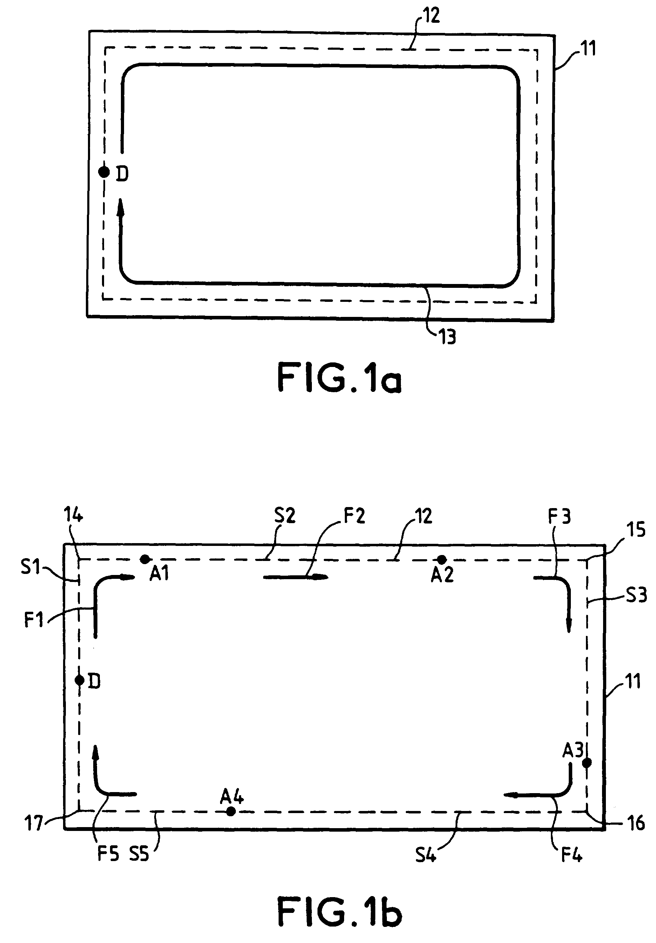

- la figure 1a, une illustration d'un procédé de soudure par laser en un seul segment ;
- la figure 1b, une illustration du procédé selon l'invention.

Sur la figure 1a est représentée une vue de dessus d'un couvercle 11 de forme rectangulaire à souder sur un cadre de boîtier. La ligne en traits pointillés 12 représente le trajet de soudure. Cette figure illustre une soudure réalisée continûment en un seul segment comme le suggère la flèche 13. Dans ce cas le faisceau du laser part du point D, parcourt le trajet 12 suivant le sens de la flèche 13 pour revenir à ce même point D. Comme cela a été exposé ci-dessus, cette méthode crée des contraintes préjudiciables à l'étanchéité du boîtier. Pour limiter, voire supprimer celles-ci, le procédé selon l'invention découpe le trajet de soudure 12 en segments, deux segments consécutifs n'étant jamais soudés l'un après l'autre, comme l'illustre la figure 1b.

Dans cette figure, le couvercle 11 est toujours représenté en vue de dessus ainsi que le trajet de soudure 12 mais celui-ci est découpé en cinq segments S1, S2, S3, S4 et S5 limités respectivement par les points D et A1, A1 et A2, A2 et A3, A3 et A4 et A4 et D. Le trajet 12 est ici découpé en cinq segments à titre d'exemple, il est évidemment possible selon l'invention de découper le contour à souder en autant de segments qu'il est nécessaire ou réalisable. Selon l'invention, le tir laser commence au point D, puis le faisceau du laser parcourt le segment S1 jusqu'au point A1 suivant le sens indiqué par la flèche F1. Une fois le segment S1 parcouru, le faisceau du laser parcourt le segment S3 depuis le point A2 jusqu'au point A3 suivant le sens de la flèche F3. Une fois le segment S3 parcouru, le faisceau parcourt le segment S5 depuis le point A4 jusqu'au point D suivant le sens de la flèche F5. Une fois le segment S5 parcouru, le faisceau parcourt le segment S2 depuis le point A1 jusqu'au point A2 suivant le sens de la flèche F2. Enfin, une fois le segment S2 parcouru, le faisceau parcourt le segment S4 depuis le point A3 jusqu'au point A4. Une fois ce dernier segment parcouru par le faisceau du laser, tout le trajet de soudure 12 à été parcouru et la fermeture du boîtier par laser est terminée. Ce procédé selon l'invention segmentant en plusieurs tronçons le trajet de soudure 12, deux segments consécutifs n'étant jamais soudés l'un à la suite de l'autre, permet de limiter les contraintes mécaniques induites par l'échauffement et la rétraction des matériaux lors de la soudure. Il est ainsi possible de prévoir le nombre de segments nécessaires compatible d'une déformation du boîtier limitant le niveau de fuite inférieur ou égal à une norme imposée. De plus, la qualité d'étanchéité obtenue sur chaque segment dès le premier passage évite des reprises supplémentaires. Au niveau des points D, A1, A2, A3 et A4, points d'intersections de deux segments consécutifs, il est préférable de prévoir un léger chevauchement des passages du faisceau du laser afin d'assurer une soudure sur tout le trajet 12. Enfin, pour assurer une parfaite étanchéité au niveau des angles 14, 15, 16 et 17 du trajet de soudure 12, ceux-ci sont inclus dans des segments et ne constituent pas des limites de segments.

Le procédé selon l'invention a été expérimenté et testé sur des macro-hybrides de longueur égale à 140 mm et de largeur égale à 70 mm. La cambrure du boîtier obtenue après fermeture est restée très faible puisque la convexité mesurée avoisinait seulement 50 µm, assurant ainsi une excellente étanchéité entre le fond du boîtier et son cadre. Le procédé selon l'invention peut être appliqué pour tous types de matériaux constituant le couvercle et le cadre du boîtier dans les limites compatibles de l'application laser.

## Revendications

1. Procédé de fermeture par laser de boîtiers de circuits électroniques notamment hybrides minimisant les contraintes mécaniques, le boîtier étant constitué d'un fond, d'un cadre et d'un couvercle métallique (11), la soudure du couvercle sur le cadre étant réalisée par déplacement du faisceau laser suivant un trajet (12) donné sur le couvercle (11) du boîtier,le trajet (12) étant fermé, caractérisé en ce que le trajet de soudure (12) est découpé en segments (S1, S2, S3, S4, S5), deux segments consécutifs (S1, S2) n'étant jamais soudés l'un à la suite de l'autre.

2. Procédé selon la revendication 1, caractérisé en ce que les angles (16, 17, 18, 19) du trajet de soudure (12) formant les coins du couvercle sont inclus chacun dans un segment et ne constituent pas une limite de segment.

3. Procédé selon la revendication 1, caractérisé en ce qu'au niveau des limites (D, A1, A2, A3, A4) des segments, les soudures se chevauchent sensiblement.

## Patentansprüche

1. Verfahren zum Verschluß von Gehäusen für elektronische Schaltungen, insbesondere Hybridschaltungen, mittels Laserstrahl, das die mechanischen Spannungen verringert, wobei das Gehäuse aus einer Basis, einem Rahmen und einem Metalldeckel (11) besteht und wobei das Aufschweißen des Deckels auf den Rahmen durch Verschiebung des Laserstrahls entlang einer gegebenen Strecke (12) auf dem Deckel (11) des Gehäuses erfolgt, die eine geschlossene Linie ist, dadurch gekennzeichnet, daß die Schweißstrecke (12) in Segmente (S1, S2, S3, S4, S5) aufgeteilt ist und daß zwei aufeinanderfolgende Segmente (S1, S2) nie unmittelbar nacheinander geschweißt werden.

2. Verfahren nach Anspruch 1, dadurch gekennzeichnet, daß die Winkel (16, 17, 18, 19) der Schweißstrecke (12), die die Ecken des Deckels bilden, im Inneren eines Segments enthalten sind und keine Grenze eines Segments bilden.

3. Verfahren nach Anspruch 1, dadurch gekennzeichnet, daß die Schweißnähte sich an den Grenzen (D, A1, A2, A3, A4) der Segmente leicht überlappen.

## Claims

1. Method for the closing, by laser, of electronic circuit packages, notably hybrid circuit packages, said method minimizing mechanical stresses, the package being constituted by a bottom, a frame and a metal lid (11), the welding of the lid to the frame being done by moving the laser beam along a given path (12) on the lid (11) of the package, the path (12) being closed, characterized in that the welding path (12) is divided into segments (S1, S2, 53, 54, S5), two consecutive segments (S1, S2) never being welded one following the other.

2. Method according to Claim 1, characterized in that the angles (16, 17, 18, 19) of the welding path (12) forming the corners of the lid are each included in a segment and do not constitute a segment boundary.

3. Method according to Claim 1 characterized in that, at the boundaries (D, A1, A2, A3, A4) of the segments, the welds substantially overlap each other.
